# EUROPEAN PATENT APPLICATION

(11) **EP 2 882 271 A1**
(43) Date of publication of application: **10.06.2015**
(21) Application number: 13824803.4
(22) Date of filing: 23.07.2013
(51) Int. Cl.: H05K 7/20

(54) **HEATING ELEMENT HOUSING DEVICE**

(30) Priority: 01.08.2012 JP 2012170781
(71) Applicant: Panasonic Intellectual Property Management Co., Ltd., Osaka-shi, Osaka 540-6207 (JP)
(72) Inventor: FUNADA, Naoyuki, Osaka-shi, Osaka 540-6207 (JP); KIYOMOTO, Kunio, Osaka-shi, Osaka 540-6207 (JP); SAHASI, Takahiro, Osaka-shi, Osaka 540-6207 (JP); MAEDA, Shogo, Osaka-shi, Osaka 540-6207 (JP)
(74) Representative: Schwabe - Sandmair - Marx
(86) International application number: PCT/JP2013/004473
(87) International publication number: WO 2014/020859

(57) **Abstract**

A heating element housing device (7) comprises a heat exchange device (6) for cooling inside a cabinet (1) by exchanging heat between internal air (8) and external air (9). An exterior fan (22a) is disposed at a bottom portion of the cabinet (1) and an interior fan (21a) is disposed at an upper portion of the cabinet (1). A case (10) houses a heat exchanger (2). The heat exchanger (2) is provided with an internal air intake port (14), an internal air outlet port (15) and an external air intake port (16). An external air outlet port (11) is provided on a side of the case (10) opposite to a cabinet door (3) for blowing out the external air (9). The exterior fan (22a) and the interior fan (21a) are both centrifugal-type fans.

## Description

### TECHNICAL FIELD

The prevent invention relates to a heating element housing device.

### BACKGROUND ART

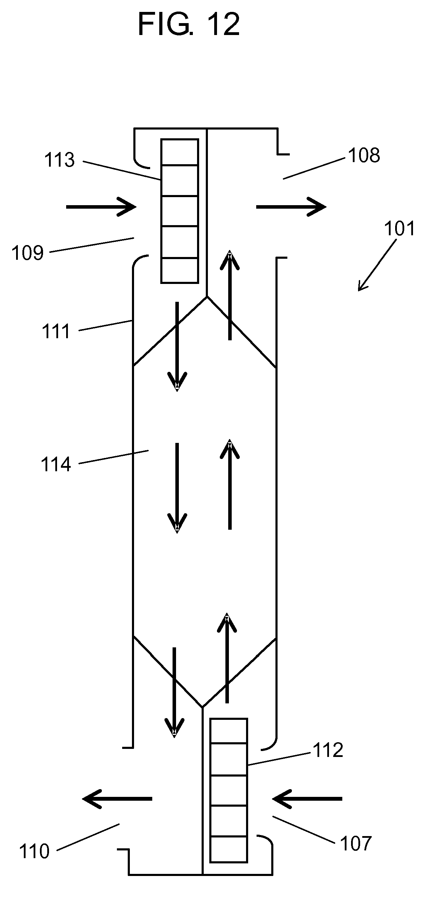

A heating element housing device is used for housing a base station for cellular phones and the like. The base station is also called as a heating element because more than tens of amperes current flow along it. That means cooling the base station for the cellular phones is extremely important for stabilizing operation of it. Conventional cooling of the base station for the cellular phones is described hereinafter with reference to Fig. 12 which is a block diagram of a conventional heat exchange device.

The heating element housing device consists of a cabinet for housing a transceiver as the heating element and the heat exchange device attached to an opening of the cabinet. As shown in Fig. 12, heat exchange device 101 is provided with main body case 111, first air blower 112 for external air disposed inside main body case 111, second air blower 113 for internal air inside the cabinet, and heat exchanger 114. Further, main body case 111 is provided with first intake port 107 and first outlet port 108 for the exterior air and second intake port 109 and second outlet port 110 for the internal air inside the cabinet. And, heat exchanger 114 exchanges heat between the external air and the internal air inside the cabinet in main body case 111 (for example, PTL 1).

The base station for the cellular phones comprises heat exchange device 101 on its wall surface. This type of conventional heat exchange device 101 comprises first air blower 112 and second air blower 113 in main body case 111. And, as heat exchanger 114 is housed so as to be sandwiched between these two air blowers, main body case 111 is obliged to be large in size. Thus, the heating element housing device comprising heat exchange device 101 on its wall surface is also obliged to be large in size.

On the other hand, the base station for the cellular phones needs to be downsized because installation of it on a roof of a building, an iron tower or a power pole has been increasingly required. Especially for installation of the base station for the cellular phones on the roof of the building, anchor bolts can't be used for installing the cabinet in post processing because waterproofing is inadequate. Thus, it is required to reduce as much of overturning moment as possible by lowering height of the cabinet. This means downsizing of the heating element housing device remains to be seen.

### Citation Lists

### Patent Literatures

PTL1: Unexamined Japanese Patent Application Publication No. 2000-161875.

### SUMMARY OF THE INVENTION

A heating element housing device of the present invention comprises a heat exchange device for cooling inside a cabinet for housing a heating element by exchanging heat between internal air inside the cabinet and external air. Further, an exterior fan for taking in the external air is disposed at a bottom portion of the cabinet and an interior fan for taking in the internal air is disposed at an upper portion of the cabinet. Further, a case for housing a heat exchanger is disposed on an outer face of a cabinet door forming a lateral face of the cabinet. Further, the heat exchanger is provided with an internal air intake port communicating with the internal fan, an internal air outlet port communicating with an inside of the cabinet and an external air intake port communicating with the external fan. Further, an external air outlet port is provided on a side of the case opposite to the cabinet door for blowing out the heat-exchanged external air through the heat exchanger. And the exterior fan and the interior fan are both centrifugal-type fans having an exterior fan intake port and an interior fan intake port respectively located below them.

Thus, the heating element housing device is provided with the centrifugal-type exterior fan for sucking the external air from the bottom portion of the cabinet. As the exterior fan is disposed so that a radial direction of the fan, obliged to be large in size, is parallel to a bottom surface of the cabinet, the exterior fan can be downsized vertically. As a result, the heating element housing device can be also downsized.

### BRIEF DESCRIPTION OF DRAWINGS

Fig. 1 is a perspective view of an installation example of a heating element housing device in accordance with an embodiment of the present invention.
Fig. 2 is a perspective view of another installation example of the heating element housing device in accordance with an embodiment of the present invention.
Fig. 3 is a bottom perspective view of the heating element housing device in Fig. 2.
Fig. 4 is an overall structure perspective view of the heating element housing device with a cabinet door open in accordance with an embodiment of the present invention.
Fig. 5 is a transparent view of the heating element housing device in accordance with an embodiment of the present invention.
Fig. 6 is a sheet block diagram of a heat exchanging element of the heating element housing device in accordance with an embodiment of the present invention.
Fig. 7 is an overall perspective view of the heat exchanging element of the heating element housing device in accordance with an embodiment of the present invention.
Fig. 8 is a sectional view of the heating element housing device in accordance with an embodiment of the present invention.
Fig. 9 is a back perspective view of a heat exchanger of the heating element housing device in accordance with an embodiment of the present invention.
Fig. 10 is a front perspective view of the heat exchanger of the heating element housing device in accordance with an embodiment of the present invention.
Fig. 11A is a duct connection diagram of an exterior fan of the heating element housing device in accordance with an embodiment of the present invention.
Fig. 11B is a detail view of a main portion of the exterior fan of the heating element housing device in accordance with an embodiment of the present invention.
Fig. 12 is a block diagram of a conventional heat exchange device.

### DESCRIPTION OF EMBODIMENTS

An embodiment of the present invention is described hereinafter with reference to the accompanying drawings.

### EMBODIMENT

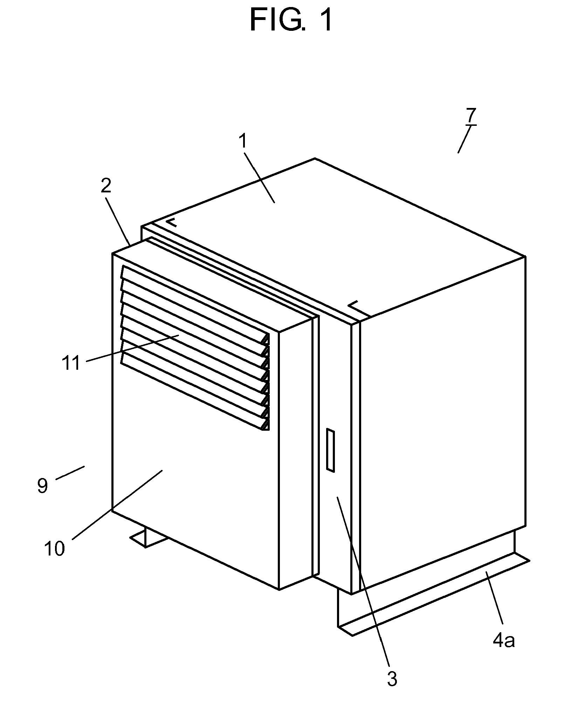

Fig.1 shows a perspective view of an installation example of a heating element housing device in accordance with the embodiment of the present invention. As shown in Fig. 1, heating element housing device 7 comprises heat exchanger 2 at a side of cabinet 1. Heat exchanger 2 is attached on cabinet door 3 which is the side of cabinet 1 so as to be opened and closed with respect to cabinet 1. Case 10 for housing heat exchanger 2 is disposed on an outer side of cabinet door 3. Further, heat exchanger 2 is provided with external air outlet port 11 for external air 9 at a front. Heating element housing device 7 of Fig. 1 shows the perspective view when it is placed on the floor. Installation rack 4a is disposed under a bottom surface of cabinet 1.

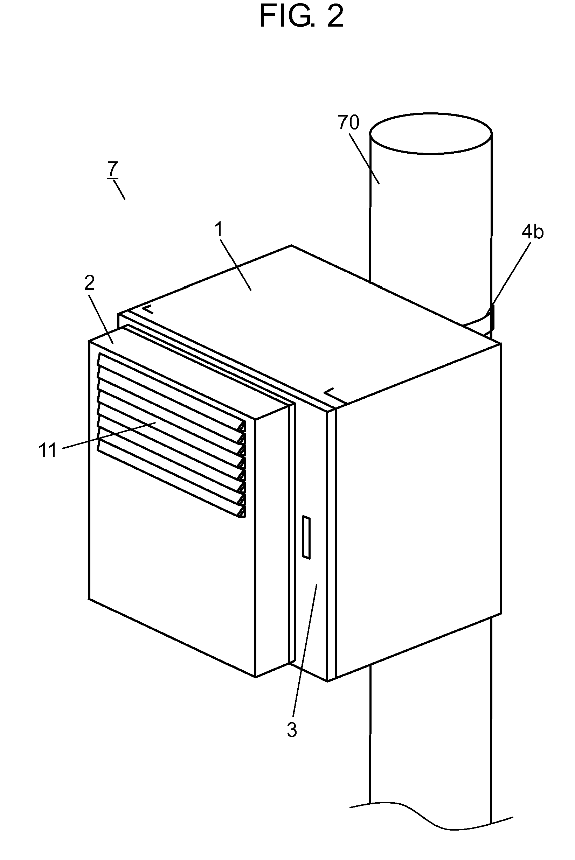

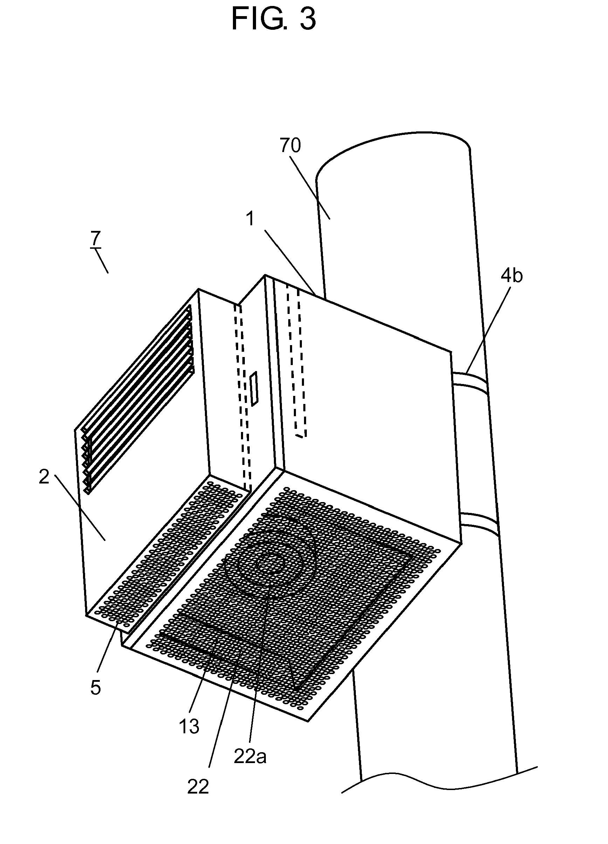

Fig. 2 is a perspective view of another installation example of the heating element housing device in accordance with the embodiment of the present invention and Fig. 3 is a bottom perspective view of the heating element housing device in Fig. 2. Heating element housing device 7 shown in Fig. 2 and Fig. 3 is in a state of being installed on power pole 70. Cabinet 1 is installed on power pole 70 so as to hold power pole 70 with power pole mounting belt 4b. And as shown in Fig. 3, the bottom surface of cabinet 1 is exterior fan intake port 13 which is an intake port of exterior fan unit 22. Further, a bottom surface of heat exchanger 2 is provided with drain outlet 5 for discharging water submerged inside heat exchanger 2.

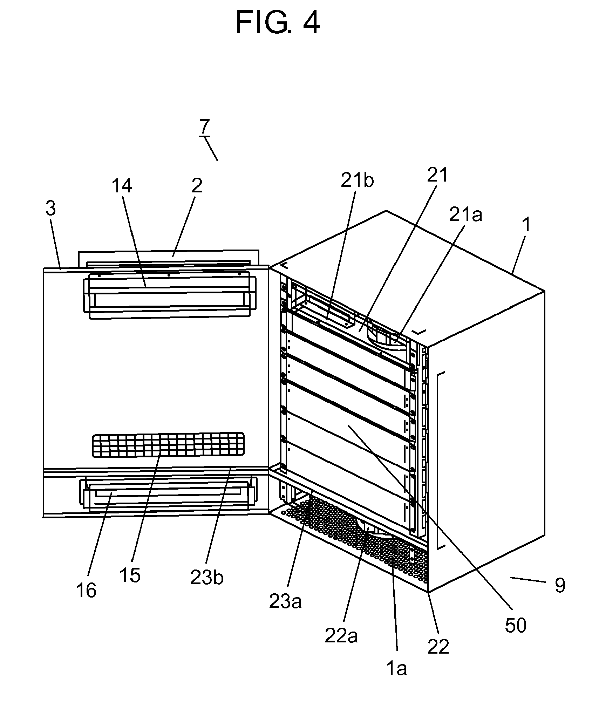

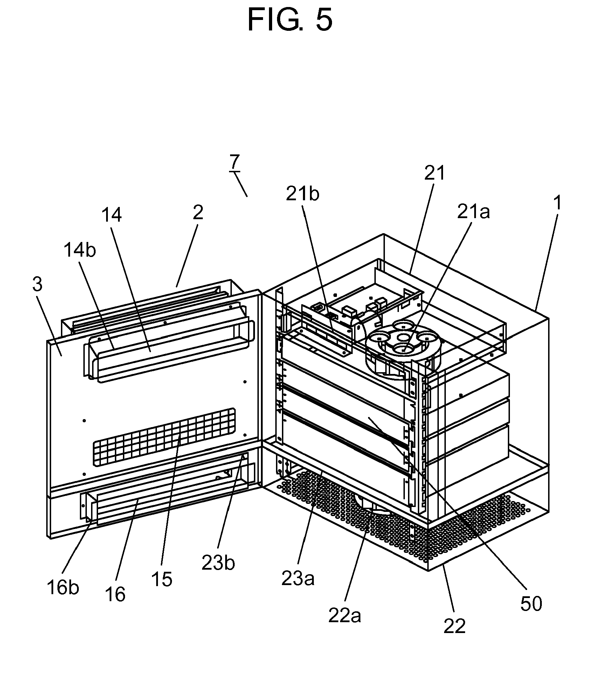

Fig. 4 is an overall structure perspective view of the heating element housing device with a cabinet door open in accordance with the embodiment of the present invention and Fig. 5 is a transparent view of the heating element housing device in accordance with the embodiment of the present invention. Heating element housing device 7 shown in Fig. 4 and Fig. 5 shows that an internal structure of cabinet 1 is exposed when cabinet door 3 is open.

As shown in Fig. 4 and Fig. 5, heat exchanger 2 and cabinet door 3 are unified. A back surface of heat exchanger 2, that is, cabinet door 3 is provided with internal air intake port 14, internal air outlet port 15 and external air intake port 16. And, internal air intake port 14 is provided with interior air duct 14b communicating with interior fan unit 21 directed toward cabinet 1. In the same way, external air intake port 16 is provided with exterior air duct 16b communicating with exterior fan unit 22 .

Cabinet 1 houses communication equipment 50 to be a heating element. And, interior fan unit 21 is disposed in an upper portion of cabinet 1. In interior fan unit 21 interior fan 21a with a centrifugal-type impeller and control box 21b are built. Cabinet bottom portion 1a of cabinet 1 is provided with exterior fan unit 22. Exterior fan 22a with the centrifugal-type impeller is built in exterior fan unit 22. Interior fan 21a and exterior fan 22a are both centrifugal-type fans. Here, internal air intake port 14, internal air outlet port 15 and external air intake port 16 communicate with interior fan 21a, an inside of cabinet 1 and exterior fan 22a respectively when cabinet door 3 is closed.

And, cabinet 1 is vertically divided into interior space for housing communication equipment 50 and exterior space for exterior fan unit 22 by partition plate 23a. And, communication equipment 50 and exterior fan 22a are respectively disposed above and below partition plate 23a. An area for exterior fan unit 22 is referred to as the exterior space because it directly communicates with external air 9. Cabinet door 3 is provided with partition member 23b for contacting partition plate 23a and for dividing the interior space and the exterior space when cabinet door 3 is closed. Partition member 23b is made of elastic material such as rubber so that it can be attached firmly to partition plate 23a when cabinet door 3 is closed.

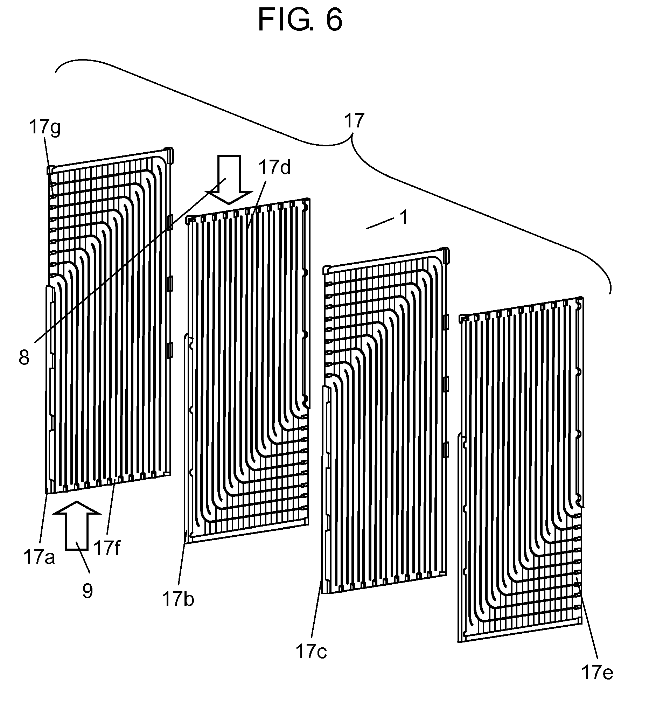

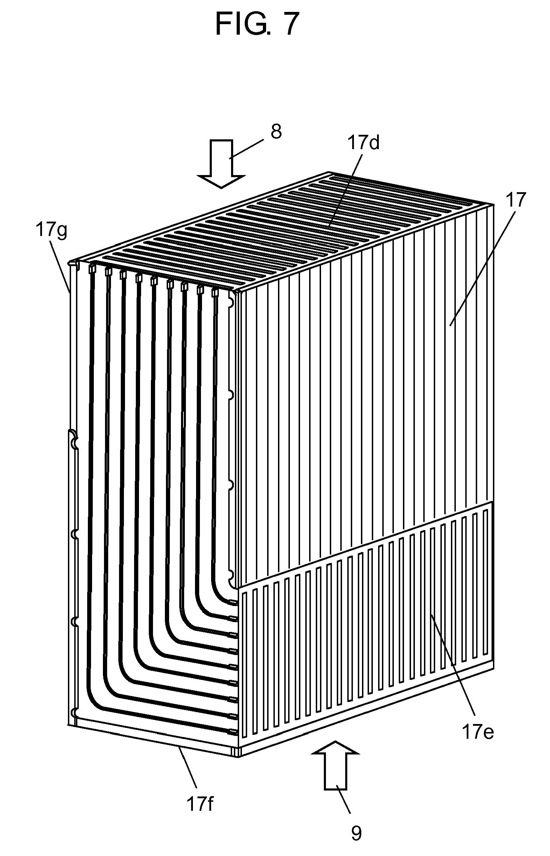

Fig. 6 is a sheet block diagram of a heat exchanging element of the heating element housing device in accordance with the embodiment of the present invention and Fig. 7 is an overall perspective view of the heat exchanging element of the heating element housing device in accordance with the embodiment of the present invention. Heat exchanging element 17 shown in Fig. 6 and Fig. 7 is provided in heat exchanger 2 shown in Fig. 1.

As shown in Fig. 6, heat exchanging element 17 is formed by first sheet 17a of rectangular-shaped and synthetic resin, second sheet 17b of rectangular-shaped and synthetic resin and third sheet 17c. Second sheet 17b is stacked on a surface of first sheet 17a and third sheet 17c is stacked on a surface of second sheet 17b so as to be spaced apart a predetermined distance from each other (hereinafter, a plurality of sheets are used as the same). Further, at surfaces of first sheet 17a, second sheet 17b and third sheet 17c, a plurality of straightening vanes are formed so as to separate the surfaces in the form of lanes not shown in figures.

Further, first sheet 17a, second sheet 17b and third sheet 17c are vertically long rectangular shaped. The straightening vane extends from one end serving as an inflow port toward other end of the sheet. This straightening vane curves toward one long end of it and leads to an outflow port. A plurality of L-shaped blow lane are formed on first sheet 17a, second sheet 17b and third sheet 17c by these straightening vanes.

In heat exchanging element 17, for internal air 8, a short blow lane is located toward cabinet 1 and a long blow lane is located toward external air 9.On the other hand, for external air 9, the long blow lane is located toward cabinet 1 and the short blow lane is located toward external air 9.And as shown in Fig. 7, a top surface of heat exchanging element 17 laminated in this way serves as inflow port 17d. Internal air 8 flows into inflow port 17d through internal air intake port 14.

Internal air 8 flowing into heat exchanging element 17 from inflow port 17d flows into cabinet 1 in Fig. 4 from outflow port 17e disposed at a right lower portion of heat exchanging element 17 in Fig. 7. Meanwhile, outflow port 17e is connected to internal air outlet port 15 in Fig. 4.

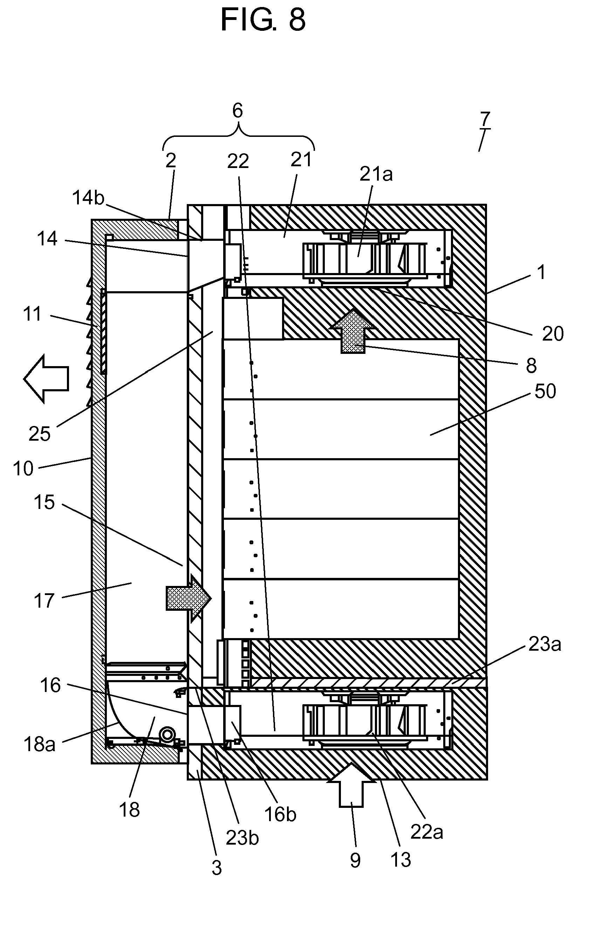

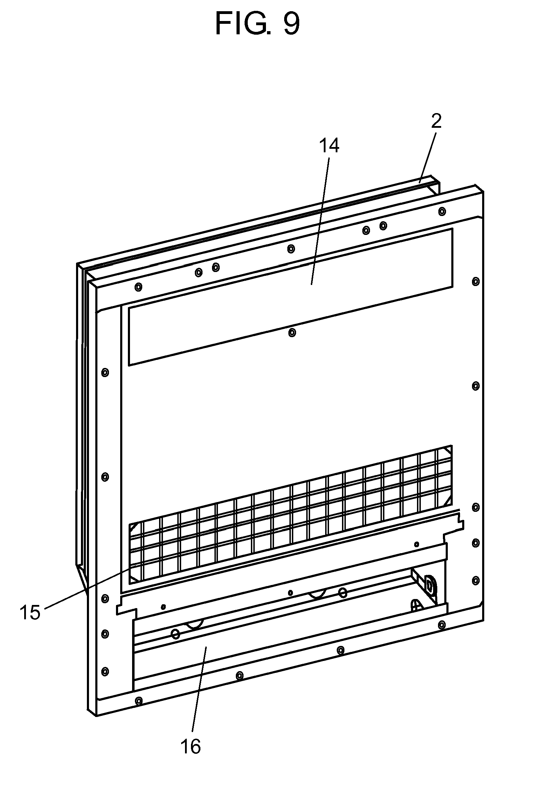

Further, external air 9 flows in from inflow port 17f disposed on a bottom surface of heat exchanging element 17 in Fig. 7 and flows out outside cabinet 1 from external air outlet port 11 in Fig. 1 through outflow port 17g disposed at a left upper portion in Fig. 7. Meanwhile, outflow port 17g is connected to external air outlet port 11 in Fig. 1. Behavior of heating element housing device 7 in such a configuration is described hereinafter with reference to Fig. 8 and Fig. 9. Fig. 8 is a sectional view of the heating element housing device in accordance with the embodiment of the present invention and Fig. 9 is a back perspective view of the heat exchanger of the heating element housing device in accordance with the embodiment of the present invention.

Internal air 8 of the interior space shown in Fig.8 and Fig.9 is warmed by operation of communication equipment 50. When interior fan 21a operates, warmed internal air 8 is sucked in and sent to heat exchanger 2 through interior air duct 14b and internal air intake port 14.

On the other hand, when exterior fan 22a operates, relatively cold external air 9 is sucked in and sent to heat exchanger 2 through exterior air duct 16b and external air intake port 16.

In heat exchanging element 17, heat exchange between warm internal air 8 and cold external air 9 is done and internal air 8 is cooled by the way that warm internal air 8 and cold external air 9 flow across between first sheet 17a, second sheet 17b and third sheet 17c in Fig. 6. Cooled internal air 8 is sent to cabinet 1 in Fig. 4 from internal air outlet port 15 again. Further, warmed external air 9 is discharged outside from external air outlet port 11.

Meanwhile, it is desirable to provide space between interior fan unit 21 and an upper portion of communication equipment 50. That is, interior fan 21a can suck internal air 8 effectively. It is also desirable to dispose cabinet partition 25 so that internal air 8 blown from internal air outlet port 15 can't be sucked directly into interior fan 21a.

Further, interior fan 21a for blowing internal air 8 is provided with interior fan intake port 20 located below it, and exterior fan 22a for blowing external air 9 is provided with exterior fan intake port 13 located below it. And, heat-exchanged external air 9 through heat exchanger 2 is discharged from external air outlet port 11 disposed on a surface of opposite to cabinet door 3 case 10. Thus, heating element housing device 7 comprises heat exchange device 6 for cooling the inside of cabinet 1 by heat exchange between internal air 8 which is air inside cabinet 1 and external air 9.

The most characteristic portion in accordance with the embodiment of the present invention is described hereinafter.

As previously described, exterior fan 22a in Fig. 8 has the centrifugal-type impeller. Exterior fan 22a and exterior fan intake port 13 are disposed face to face, and exterior fan 22a sucks external air 9 through the bottom surface of cabinet 1. In this configuration, a vertical dimension of exterior fan 22a is subject to a length of an impeller rotating shaft of exterior fan 22a. And an impeller diameter of exterior fan 22a can be fully expanded approximately to ends of the bottom surface of cabinet 1, thus, a thin type impeller is used. This means exterior fan unit 22 is made thin. And, exterior fan unit 22 and cabinet 1 are separated by partition plate 23a and partition member 23b, internal air 8 is therefore effectively cooled without mixing internal air 8 with external air 9.

Combination of heat exchanger 2, interior fan unit 21 and exterior fan unit 22 allows heating element housing device 7 in accordance with the embodiment of the present invention to be applied to a wide variety of communication equipment 50 and cabinet 1. This means heat exchanger 2 of heating element housing device 7 can increase its size to cool huge communication equipment 50 and cabinet 1. If air flow is insufficient, specifications of interior fan unit 21 and exterior fan unit 22 can be changed. Heating element housing device 7 is configured to suck external air 9 from the bottom surface of cabinet 1, thus, no obstacles exist near exterior fan intake port 13 when heating element housing device 7 is installed on power pole 70 at a high attitude as shown in Fig. 2. As a result, external air 9 is effectively introduced. Further, if it rains, absorption of rain water can be reduced since heating element housing device 7 is configured to suck external air 9 from the bottom surface of cabinet 1. Further, the bottom surface of cabinet 1 has no effect by sunlight, an increase in temperature by sunlight can be therefore limited and cooling capacity is improved.

Furthermore, if heating element housing device 7 is installed on the floor, sound generated from exterior fan 22a is emitted in a downward direction. A noise emitted around cabinet 1 can be therefore reduced.

In the same manner, interior fan unit 21 can be also slim because it has interior fan 21a with the centrifugal-type impeller.

Meanwhile, in accordance with the embodiment of the present invention, exterior fan unit 22 and interior fan unit 21 are disposed apart in the cabinet, however it is not always necessary to make them into a unit, the inside of cabinet 1 only have to be separated into the interior space and the exterior space.

Additionally, it is explained that the cabinet is separated into the interior space and the exterior space with partition plate 23a, however, the interior space of the cabinet can be configured to be made box-shape and exterior fan unit 22 can be separately attached to the cabinet.

As shown in Fig. 5, control box 21b is disposed inside interior fan unit 21. Control box 21b controls operation of interior fan 21a and exterior fan 22a. In Fig. 4, control box 21b is disposed inside interior fan unit 21, however, it's possible to dispose it in an area for communication equipment 50 inside cabinet 1.

As shown in Fig. 8, external air chamber 18 is disposed between external air intake port 16 and inflow port 17f in Fig. 7. Curved external air guide 18a is disposed inside external air chamber 18 for smoothly sending external air 9 into inflow port 17f.

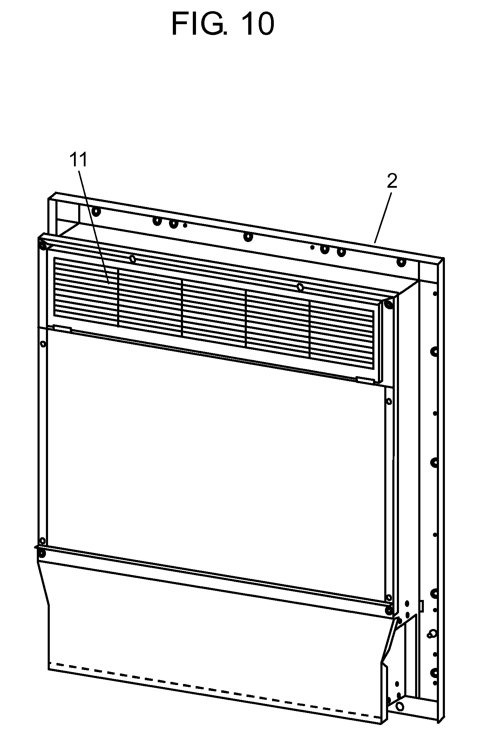

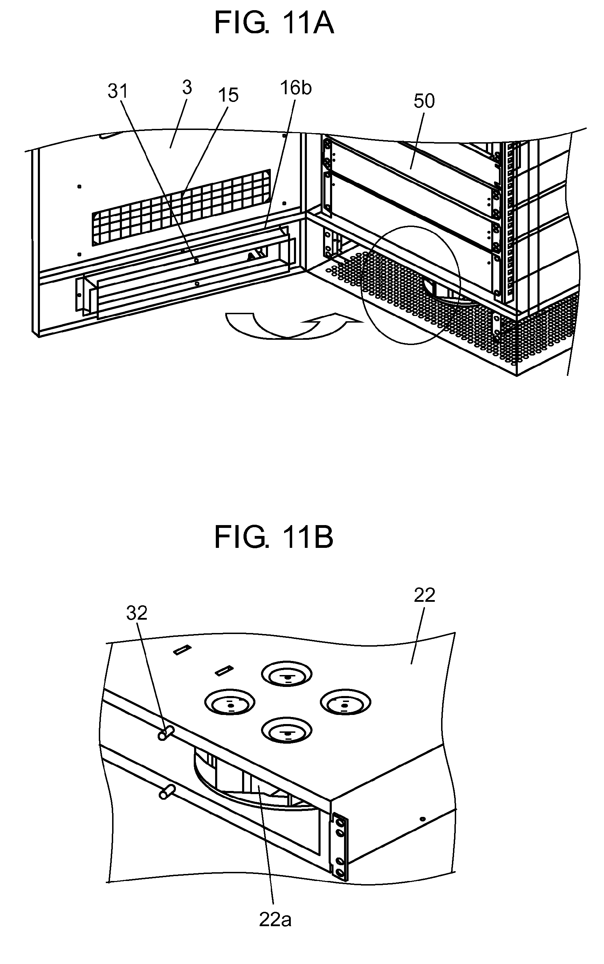

Fig. 10 is a front perspective view of the heat exchanger of the heating element housing device in accordance with the embodiment of the present invention, Fig. 11A is a duct connection diagram of the exterior fan of the heating element housing device in accordance with the embodiment of the present invention and Fig. 11B is a detail view of a main portion of the exterior fan of the heating element housing device in accordance with the embodiment of the present invention. As shown in Fig. 10, Fig. 11A and Fig. 11B, external air duct 16b is provided with positioning hole 31 and external fan unit 22 is provided with positioning pin 32. Positioning pin 32 is located so as to fit to positioning hole 31 when cabinet door 3 is closed.

This configuration allows for accurate connection between external fan unit 22 and external air duct 16b and separation between the external space and the internal space of cabinet 1.

### INDUSTRIAL APPLICABILITY

Thus, a heating element housing device of the present invention is extremely useful as a cooling unit for a base station, having a limited footprint, of communication equipment, and other outdoor equipment.

### REFERENCE MARKS IN THE DRAWINGS

- 1: cabinet
- 1a: bottom portion of cabinet
- 2: heat exchanger
- 3: cabinet door
- 4a: installation rack
- 4b: power pole mounting belt
- 5: drain outlet
- 6: heat exchange device
- 7: heating element housing device
- 8: internal air
- 9: external air
- 10: case
- 11: external air outlet port
- 13: exterior fan intake port
- 14: internal air intake port
- 14b: interior air duct
- 15: internal air outlet port
- 16: external air intake port
- 16b: exterior air duct
- 17: heat exchanging element
- 17a: first sheet
- 17b: second sheet
- 17c: third sheet
- 17d, 17f: inflow port
- 17e, 17g: outflow port
- 18: external air chamber
- 18a: external air guide
- 20: interior fan intake port
- 21: interior fan unit
- 21a: interior fan
- 21b: control box
- 22: exterior fan unit
- 22a: exterior fan
- 23a: partition plate
- 23b: partition member
- 25: cabinet partition
- 31: positioning hole
- 32: positioning pin
- 50: communication equipment (heating element)
- 70: power pole

## Claims

1. A heating element housing device having a cabinet for housing a heating element and a heat exchange device for cooling inside the cabinet by heat exchange between internal air inside the cabinet and external air, the heating element housing device comprising:
an external fan for blowing the external air into a bottom portion of the cabinet;
an internal fan for blowing the internal air into an upper portion of the cabinet; and
a case for housing a heat exchanger disposed on an outer face of a cabinet door forming a lateral face of the cabinet,
wherein, the heat exchanger is provided with an internal air intake port communicating with the internal fan,
an internal air outlet port communicating with an inside of the cabinet and
an external air intake port communicating with the exterior fan, and
wherein an external air outlet port is disposed on a surface of the case opposite to the cabinet door for blowing out the heat-exchanged external air through the heat exchanger, and the exterior fan and the interior fan are centrifugal-type fans having an exterior fan intake port and an interior fan intake port respectively located below them.

2. The heating element housing device according to claim 1, wherein the inside of the cabinet is vertically separated into two spaces by a partition plate for disposing the heating element above the partition plate and the exterior fan below the partition plate.

3. The heating element housing device according to claim 1, wherein an exterior fan unit for housing the exterior fan is disposed at the bottom portion of the cabinet.
